(19)

Europäisches
Patentamt

European
Patent Office

Office européen
des brevets

(11) **EP 2 884 538 A1**

(12) **EUROPEAN PATENT APPLICATION**

(43) Date of publication:
**17.06.2015 Bulletin 2015/25**

(51) Int Cl.:
*H01L 29/36* (2006.01)     *H01L 29/808* (2006.01)
*H01L 29/872* (2006.01)     *H01L 29/06* (2006.01)

(21) Application number: **13197530.2**

(22) Date of filing: **16.12.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **ABB Technology AB
8050 Zürich (CH)**

(72) Inventor: **Bauer, Friedhelm
6714 Semione (CH)**

(74) Representative: **ABB Patent Attorneys
c/o ABB Schweiz AG
Intellectual Property CH-IP
Brown Boveri Strasse 6
5400 Baden (CH)**

(54) **Power semiconductor device**

(57)     Disclosed is a semiconductor device comprising a semiconductor slab (1), in particular a semiconductor wafer or semiconductor die, the semiconductor slab having a first main side (101) and a second main side (102), said second main side being parallel to the first main side at a distance with respect to a first direction; and a bulk layer (10) of a first conductivity type located between the first main side and the second main side, and extending in the first direction between a distance $d_{b1}$ from the first main side with $d_{b1} >= 0$ and a distance $d_{b2}$ from the first main side with $d_{b2} > d_{b1}$, and in a second direction perpendicular to the first direction, and with a first floating sublayer formed within the bulk layer, said first floating sublayer comprising a plurality of, preferably at least 10, floating regions (11) of a second conductivity type located between a first distance from the first main side and a second distance from the first main side, and spaced apart from one another with respect to the second direction, a first homogenous bulk sublayer located between the first main side and the first floating sublayer; a second homogenous bulk sublayer located between the first floating sublayer and the second main side; the semiconductor device further comprising a first main electrode (31) provided on the first main side and a second main electrode (32) provided on the second main side, wherein an enhancement region (12) of the first conductivity type is formed adjacent, preferably contiguous, to at least one of the floating regions in the first floating sublayer; and the enhancement region has a higher doping concentration than the bulk layer.

Fig. 3

EP 2 884 538 A1

**Description**

*Field of invention*

The invention relates to the field of power electronics. In particular, it relates to a semiconductor device according to the preamble of claim 1.

*Background of the invention*

Thickness and doping density of a drift region provided in unipolar power semiconductor devices, in particular Metal-Oxide-Silicon field effect transistors (MOSFETs), junction field effect transistors (JFETs), Schottky barrier diodes (SBDs), determine decisively an on-state resistance $R_{on}^{NPT}$ and thus an on-state voltage drop; and a blocking capability of the device, i.e. a maximum voltage $V_{br}^{NPT}$ that may be applied between a first and a second main electrode of the device without occurrence of any breakdown. For devices based on a so called non-punch-through (NPT) design, there thus exists a trade-off between said two characteristics, which may mathematically by expressed as

$$R_{on}^{NPT} = \frac{4 \bullet \left( V_{br}^{NPT} \right)^2}{\varepsilon \bullet \mu_n \bullet A \bullet E_{crit}^3} \qquad \text{(Eq. 1)}$$

Equation (Eq. 1), which is well known to persons skilled in the art, represents the so called material limit; and is often cited in comparisons between silicon semiconductor devices and semiconductor devices based on wide-bandgap semiconductor materials, in particular SiC. It gives the minimum on-resistance $R_{on}$ for a simple, straight forward n-doped drift layer with a breakdown voltage of $V_{br}$. There has always been a large interest to find advanced semiconductor concepts which allow overcoming this limit. For silicon semiconductor devices, vertical superjunctions have been suggested in order to reach this goal, for example in so called superjunction power MOSFETs). While this approach has already led to a large economic success for power MOSFETs based on silicon, it is not viable for an implementation in SiC due to the fact that a manufacturing process for superjunctions relies on heavy dopant diffusion, which is easily achievable with silicon. Dopants in SiC, however, are largely immobile when subjected to a high temperature diffusion step so that no sufficient diffusion for forming superjunctions occurs.

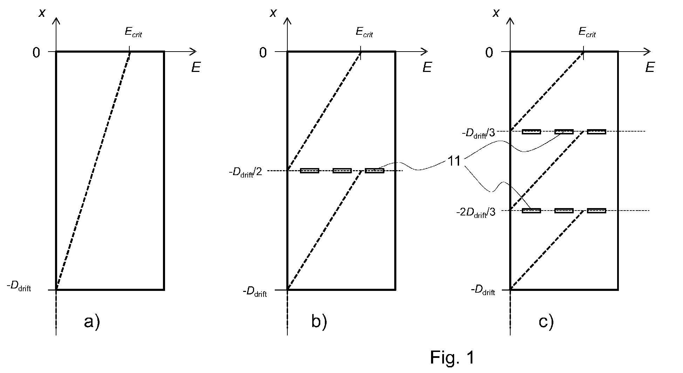

In order to overcome the material limit for SiC semiconductor devices, various approaches have recently been proposed which are based on providing a buried grid of p-doped floating regions within the n-doped drift region. It was first realized in silicon MOSFETs as e.g. described in US patent application publication 2009/0014792 A1, which is hereby included by reference in its entirety; and later tested and confirmed using a SiC SBD as e.g. described in US patent application publication 2010/0155876 A1, which is hereby also included by reference in its entirety. The approach is illustrated in Fig. 1 for the SBD: the solid rectangles represent an n-doped drift layer required to withstand the blocking voltage when depleted, and having a thickness $D_{drift}$. A main blocking junction is located at a top surface at $x=0$, which in general is parallel to a first main side of a semiconductor slab in which the junction is formed. The standard case as shown in Fig. 1a) highlights a breakdown situation when the electric field reaches the critical electric field $E_{crit}$ at the main blocking junction. Normally, for a non-punch-through design, the doping of a unipolar drift layer is chosen such that the full structure is depleted at the desired breakdown voltage (electric field reaches the bottom), such that $E(x=-D_{drift}) = 0$.

In Figs 1b) and 1c), buried grids of highly p-doped floating regions 11 are arranged at selected depths of the drift layer. The presence of the p-doped floating regions 11 enhances the development of a depletion layer similar to p-guard rings in planar terminations, i.e., once the depletion region from the anode side reaches the buried p-doped floating regions 11, an electric field within these regions is pinned due to punch-through between the p-doped floating regions 11 and an anode at $x=0$, and then a new depletion layer develops from an underside of the p-doped floating regions 11 towards a cathode located at $x=-D_{drift}$.

As the voltage across the depletion layer is given by the integral of the electric field over x, which integral is identical for all three structures, they all have the same breakdown voltage. However, for the electric fields to decay faster in the y-direction on both sides of the floating region, a higher doping concentration is required in the bulk regions, which in turn leads to a reduced on-state resistance. Thus, with the approach as described above, the doping concentration of the n-drift region can be substantially increased and hence the on-state resistance of a power semiconductor device may be strongly reduced.

As may be seen from Fig. 1b), a single buried floating grid in the middle of the n-drift layer can theoretically help to decrease the resistance of this layer by 50% (increase in conductivity by a factor of 2). As illustrated in Fig. 1c), an arrangement of two buried layers arranged at a $D_{drift}$ /3 spacing can bring the resistance down to 33%. Obviously, the possibility to massively reduce $R_{on}$ makes this approach particularly interesting for SiC HV power MOSFETs (5 - 10 KV range).

However, for the approach as described above to work sufficiently well, appropriate spacing and width of the p-doped floating regions 11 in a direction parallel to the top surface have to be selected. If the spacing is chosen too large or the width too small, or both, the electric field will not efficiently be pinned to zero in a plane located at the top surface of the p-doped floating regions 11. On the other hand, as no current will flow through the p-doped floating regions 11 during the on-state of the semiconductor device, an effective cross section available for current conduction will be reduced, which is detrimental to the reduction is resistance achieved by the increased doping.

It is an object of the invention to provide a power semiconductor device of the type mentioned initially with improved performance, in particular with reduced on state resistance, in particular for a given breakdown voltage; and/or with increased breakdown voltage, in particular with an increased range of available break down voltages as compared to known devices with floating regions.

### Description of the invention

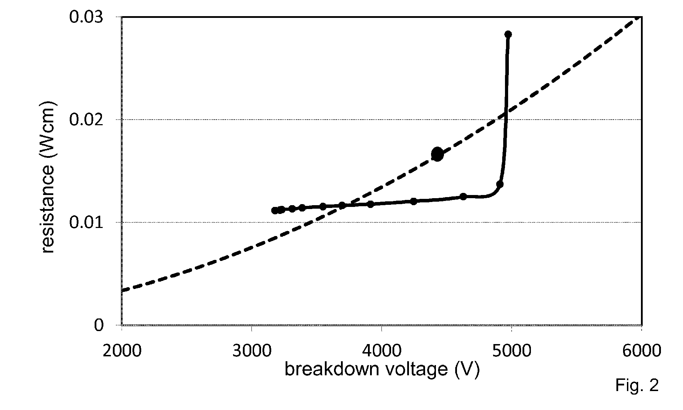

The invention is based on the observation that a compromise/trade-off results between blocking capability, represented by a breakdown voltage, and on-state resistance. To illustrate this trade-off, an SiC semiconductor device comprising a conventional uniform, homogenously (n-)-doped bulk layer of 40 $\mu$m thickness and with an n-type doping concentration of $N_D$= 4x10$^{15}$ cm$^{-3}$ as a drift layer was considered. The dashed curve in Fig. 2 represents a so called limit curve, i.e. a plot of Eq. 1 with typical values as widely known assumed for $E_{crit}$ in SiC. As indicated by the dot on the limit curve, such a bulk layer is capable of supporting a blocking voltage of 4300V prior to breakdown. Its corresponding on-resistance at a temperature of 400 K amounts to 0.016 $\Omega$·cm. This conventional drift layer will be used as a reference when compared to various p-buried floating layer/floating junction drift regions.

To illustrate the trade-off mentioned above, an arrangement with p-doped floating regions 11 located within the bulk layer as described above was considered, wherein an overall thickness of the bulk layer remained fixed at 40 $\mu$m. The doping is increased up to $N_{Df}$ = 6x10$^{15}$ cm$^{-3}$. If no p-doped floating regions 11 were present, this bulk layer would have a 400 K breakdown voltage of 3086 V. The solid curve in Fig. 2 illustrates results of 2-dimensional numerical simulations for breakdown voltage vs. on-state resistance, for a bulk layer having p-doped floating regions 11 provided therein with their (vertical) middle arranged at a (vertical) middle of the bulk layer, i.e., at a depth of 20 $\mu$m from either surface of the bulk layer for various spacings, each represented by a dot and decreasing from left to right, between 2 $\mu$m (represented by the rightmost dot on the solid curve) and 10 $\mu$m (represented by the leftmost dot on the solid curve). A constant width of 2 $\mu$m was assumed for the p-doped floating regions 11. Further, it was assumed that the structure as considered in two dimensions extends infinitely into a third dimension, i.e., the p-doped floating regions 11 form a system of parallel stripes with variable inter-stripe spacing between them. As may be seen, for either extremely narrow or coarse stripe spacing, the bulk layer having p-doped floating regions 11 will lose its advantage against a - thinner or thicker - conventional bulk layer.

It was found that the object as indicated above may be achieved by a semiconductor device comprising a semiconductor slab, in particular a semiconductor wafer or semiconductor die, the semiconductor slab having a first main side and a second main side, said second main side being parallel to the first main side at a distance with respect to a first direction; and a bulk layer of a first conductivity type located between the first main side and the second main side, and extending in the first direction between a distance $d_{b1}$ from the first main side with $d_{b1}$ >= 0 and a distance $d_{b2}$ from the first main side with $d_{b2}$ > $d_{b1}$, and in a second direction perpendicular to the first direction, and with a first floating sublayer formed within the bulk layer, said first floating sublayer comprising a plurality of, preferably at least 10, floating regions of a second conductivity type located between a first distance from the first main side and a second distance from the first main side, and spaced apart from one another with respect to the second direction, a first, preferably homogenous, bulk sublayer located between the first main side and the first floating sublayer; a second, preferably homogenous, bulk sublayer located between the first floating sublayer and the second main side; the semiconductor device further comprising a first main electrode provided on the first main side and a second main electrode provided on the second main side, wherein an enhancement region of the first conductivity type is formed adjacent, preferably contiguous, to at least one of the floating regions in the first floating sublayer; and the enhancement region has a higher doping concentration than the bulk layer.

Further advantages according to the present invention will be apparent from the dependent claims.

*Brief description of the drawings*

The subject matter of the invention will be explained in more detail in the following text with reference to the attached drawings, in which:

FIG. 1    illustrates an electric field distribution in a n-doped drift region with a buried grid of p-doped floating regions according to the prior art,

FIG. 2    illustrates results of 2-dimensional numerical simulations for breakdown voltage vs. on-state resistance for a bulk layer with p-doped floating regions,

FIG. 3    schematically shows a sectional view of a Schottky barrier diode in accordance with the present invention,

FIG. 4    schematically shows a sectional view of a metal-oxide-silicon field effect transistor in accordance with the present invention,

FIG. 5    schematically shows a sectional view of a junction field effect transistor in accordance with the present invention,

FIG. 6    schematically shows a sectional view of a junction barrier Schottky rectifier in accordance with the present invention,

FIG. 7    schematically shows sectional views of grid sections for various exemplary arrangements of additional n-doped enhancement regions,

FIG. 8    [Fig. 6 from ID] shows results of numerical simulations of on-state resistance as a function of breakdown voltage for various exemplary arrangements of additional n-doped enhancement regions,

FIG. 9    [Fig. 7 from ID] shows results of numerical simulations of on-state resistance as a function of breakdown voltage for various exemplary arrangements of additional n-doped enhancement regions,

FIG. 10    schematically shows partial top views of cuts at $x_{float}$ parallel to the *y-z*-plane through various semiconductor devices in accordance with the present invention.

The reference symbols used in the figures and their meaning are summarized in the list of reference symbols. Generally, alike or alike-functioning parts are given the same reference symbols. The described embodiments are meant as examples and shall not confine the invention.

*Detailed description of preferred embodiments*

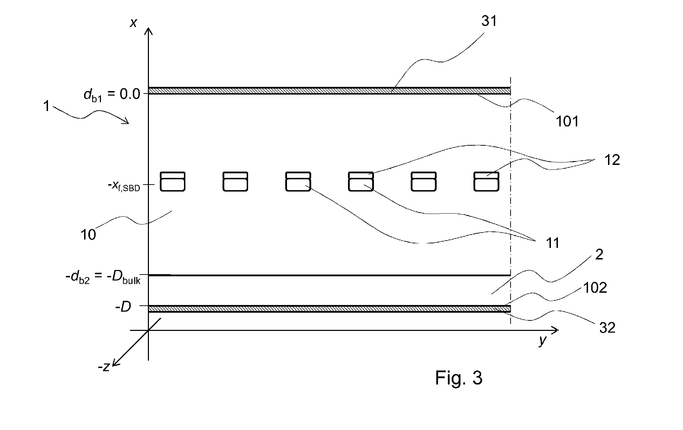

FIG. 3 shows a Schottky barrier diode (SBD) representing a first embodiment of a semiconductor device in accordance with the present invention. SBD 1 comprises a semiconductor slab 1, which was e.g. obtained from a SiC wafer through a plurality of process steps, generally including thinning, layer growing, implant and deposition and diffusion of dopants, and/or dicing. The semiconductor slab has a first main side 101 located at $x = 0$ and a second main side 102, said second main side 102 being *arranged* parallel to the first main side 101 at a distance $D$ in (-x)-direction, i.e. at $x = -D$, wherein the x-direction represents a first direction, also referred to as vertical direction, corresponding to a first spatial dimension of the device. A bulk layer 10 and an n-doped, preferably (n+)-doped, substrate layer 2 are located between the first main side 101 and the second main side 102, and extend in a direction at least essentially parallel to the first and second main sides 101, 102 and parallel to one another. The bulk layer 10 is (n-)-doped with an at least essentially homogeneous background doping concentration of $N_{D0} = 6 \times 10^{15}$ cm$^{-3}$, representing a doping of a first conductivity type. A first side of the bulk layer 10 is arranged contiguous to the first main side, i.e. at $x = -d_{b1} = 0$. The bulk layer has a thickness $D_{bulk}$, a second side is thus arranged at $x = -d_{b2} = -D_{bulk}$, and preferably contiguous to a first side of the substrate layer. An anode electrode 31 is provided on the first main side, adjacent and contiguous to the bulk layer 10, and with a Schottky contact formed between anode electrode and bulk layer 10. Likewise, a cathode electrode 32 is provided on the second main side, adjacent and contiguous to the substrate layer, and with an ohmic contact formed between cathode electrode and substrate layer.

A grid of isolated, p-doped floating regions 11 having a net doping concentration $N_{float}(p) > N_{D0}$ is formed in the bulk layer, preferably at least approximately at a vertical middle of the bulk layer, most preferably at $x_{float} = -D_{bulk}/2 := x_{f,SBD}$. In a vertical direction, the p-doped floating regions 11 have a thickness $D_f << D_{bulk}$, preferably $D_f < D_{bulk}/10$, most preferably $D_f < D_{bulk}/100$, and extend in a vertical direction between $x = -d_{f1} = -(D_{bulk} - D_f)/2$ and $x = -d_{f2} = -(D_{bulk} + D_f)/2$. In a first horizontal direction represented by the y-direction of Fig. 1 and corresponding to a second spatial dimension of the device, the p-doped floating regions 11 have a width $w_f$, typically in a range $0,5\mu m < w_f < 10\mu m$, preferably $1\mu m < w_f < 3\mu m$ and a spacing $s_f$, typically in a range $1\mu m < s_f < 10\mu m$, preferably $2\mu m < s_f < 5\mu m$. Thus, the grid is preferably periodic in *y*-direction with a period of $\Lambda y = w_f + s_f$.

An n-doped enhancement region having a net doping concentration $N_{enh}(n) > N_{D0}$, preferably $100N_{D0} > N_{enh}(n) > 2N_{D0}$, most preferably $50N_{D0} > N_{enh}(n) > 5N_{D0}$, is formed above and contiguous to each floating region, i.e. between the floating region and the first main side. In the vertical direction, the n-doped enhancement regions 12 have a thickness

$D_e << D_{bulk}$, preferably $D_e < D_{bulk}/10$, most preferably $D_e < D_{bulk}/100$, and extend in a vertical direction between $x = -d_{e1} = - (D_{bulk} - D_f)/2$ and $x = -d_{e2} = - (D_{bulk} - D_f)/2 + D_e$.

The grid of p-doped floating regions 11 together with the enhancement regions 12 may be regarded as a floating sublayer which is located within the bulk layer, and which separates a first homogenous bulk sublayer located above the floating sublayer from a second homogenous bulk sublayer located below the floating sublayer, with both homogenous bulk sublayers having at least approximately identical thickness.

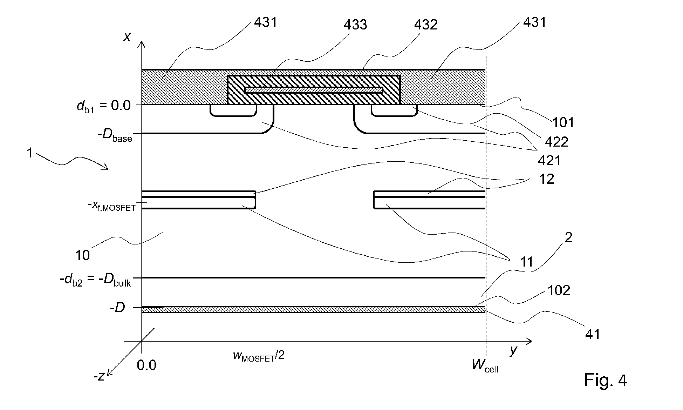

FIG. 4 shows a sectional view of an individual cell of a metal-oxide-silicon field effect transistor (MOSFET) representing a second embodiment of a semiconductor device in accordance with the present invention. The MOSFET cell also comprises a semiconductor slab 1, which was e.g. obtained from a SiC wafer through a plurality of process steps, generally including thinning, layer growing, implant and deposition and diffusion of dopants, and/or dicing. The semiconductor slab has a first main side 101 located at $x=0$ and a second main side 102, said second main side 102 being arranged parallel to the first main side 101 at a distance $D$ in (-x)-direction, i.e. at $x = -D$. Again, a bulk layer 10 and a substrate layer are located between the first main side 101 and the second main side 102, and extend in a direction at least essentially parallel to the first and second main sides 101, 102 and parallel to one another. The bulk layer 10 is (n-)-doped with an at least essentially homogeneous background doping concentration of $N_{D0} = 6\times10^{15}$ cm$^{-3}$. A drain electrode 41 is provided on the second main side, adjacent and contiguous to the substrate layer, and with an ohmic contact formed between drain electrode 41 and an n-doped, preferably (n+)-doped, substrate layer 2. Source electrodes 431 are provided on peripheral areas of the MOSFET cell contiguous to the first main side and connected to one another through an electrically conducting connection; and also with ohmic contacts formed between source electrodes 431 and semiconductor slab 1. An insulator 432, preferably SiO$_2$, is formed on and contiguous to the first main side in a horizontal central area of the MOSFET cell. A gate electrode 433 is disposed over said horizontal central area of the MOSFET cell, and electrically insulated from semiconductor slab 1 by the insulator 432. p-doped base regions 421 having a thickness $D_{base} << D_{bulk}$ are formed in the bulk layer 10 at peripheral areas of the MOSFET cell, and adjacent to the first main side. n-doped, preferably (n+)-doped, source regions 422 are formed in the base regions 421, and contiguous to the first main side. Top sides of the p-doped base regions 421 are contiguous to the first main side outside of an area in which the n-doped source regions 422 are formed.

Isolated, p-doped, preferably (p+)-doped, floating regions 11 having a net doping concentration $N_{float}(p) > N_{D0}$ are formed in the bulk layer at $x_{float} = - (D_{bulk} + D_{base}) / 2 := x_{f,MOSFET}$ at peripheral regions of the MOSFET cell. In a vertical direction, the p-doped floating regions 11 have a thickness $D_f << D_{bulk}$, preferably $D_f < D_{bulk}/10$, most preferably $D_f < D_{bulk}/100$, and extend in a vertical direction between $x = -d_{f1} = - (D_{bulk} + D_{base} - D_f)/2$ and $x = -d_{f2} = - (D_{bulk} + D_{base} + D_f)/2$. In a first horizontal direction, corresponding to a $y$-direction in Fig. 1, the p-doped floating regions 11 have a width $w_f/2$, typically in a range $0,5\mu m < w_f < 10\mu m$, preferably $1\mu m < w_f < 3\mu m$ and a spacing $s_f$ typically in a range $1\mu m < s_f < 10\mu m$, preferably $2\mu m < s_f < 5\mu m$.

Again, n-doped enhancement regions 12 having a net doping concentration $N_{enh}(n) > N_{D0}$, preferably $100 N_{D0} > N_{enh}(n) > 2N_{D0}$, most preferably $50 N_{D0} > N_{enh}(n) > 5N_{D0}$, are formed above and contiguous to a plurality of floating regions, preferably to each floating region, i.e. between the floating region and the first main side. In a vertical direction, the n-doped enhancement regions 12 have a thickness $D_e << D_{bulk}$, preferably $D_e < D_{bulk}/10$, most preferably $D_e < D_{bulk}/100$, and extend in a vertical direction between $x = -d_{e1} = -(D_{bulk} + D_{base} - D_f)/2$ and $x = -d_{e2} = -(D_{bulk} + D_{base} - D_f)/2 + D_e$.

An actual MOSFET device comprises a plurality, typically several hundred to a few thousands, of individual cells as shown in Fig. 4, arranged contiguous to one another in $y$-direction, each cell having a width $w_{MOSFET}$ typically in a range $5\mu m < w_{MOSFET} < 50\mu m$, preferably $10\mu m < w_{MOSFET} < 20\mu m$. Thus, the p-doped floating regions 11 form a grid with a period $\Lambda_y \approx w_{MOSFET}$; preferably with $\Lambda_y = w_{MOSFET}$ within a contiguous bulk layer of the MOSFET device.

The grid of p-doped floating regions 11 together with the enhancement regions 12 may again be regarded as a floating sublayer which is located within the contiguous bulk layer, and which separates a first homogenous bulk sublayer located above the floating sublayer from a second homogenous bulk sublayer located above the floating sublayer, with both homogenous bulk sublayers having at least approximately identical thickness. Between the first homogenous bulk sublayer and the first main side, another sublayer is formed, which comprises the p-doped base regions 421 as well as a horizontal central region of the bulk layer located between the p-doped base regions 421, and between $x=0$ and $x=-D_{base}$, which may be regarded as a MOSFET characteristic sublayer.

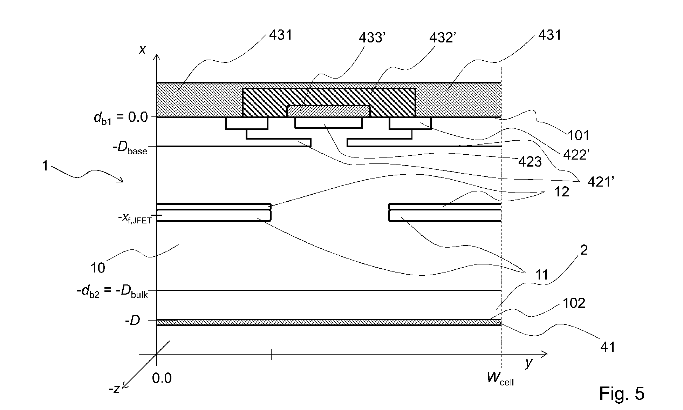

FIG. 5 shows a sectional view of an individual cell of a junction field effect transistor (JFET) representing a third embodiment of a semiconductor device in accordance with the present invention. The JFET cell again comprises a semiconductor slab 1, which was e.g. obtained from a SiC wafer through a plurality of process steps, generally including thinning, layer growing, implant and deposition and diffusion of dopants, and/or dicing. The semiconductor slab has a first main side 101 located at $x=0$ and a second main side 102, said second main side 102 being *arranged* parallel to the first main side 101 at a distance $D$ in (-$x$)-direction, i.e. at $x = -D$. Again, a bulk layer 10 and an n-doped, preferably (n+)-doped, substrate layer 2 are located between the first main side 101 and the second main side 102, and extend in a direction at least essentially parallel to the first and second main sides 101, 102 and parallel to one another. The bulk layer 10 is (n-)-doped with an at least essentially homogeneous background doping concentration of $N_{D0} = 6\times10^{15}$ cm$^{-3}$.

A drain electrode 41 is provided on the second main side, adjacent and contiguous to the substrate layer, and with an ohmic contact formed between drain electrode 41 and substrate layer. Source electrodes 431 are provided on peripheral areas of the JFET cell contiguous to the first main side and connected to one another through an electrically conducting connection; and also with ohmic contacts formed between source electrodes 431 and semiconductor slab 1. An insulator 432' is formed on and contiguous to the first main side in a horizontal central area of the JFET cell. A gate electrode 433' is disposed over said horizontal central area of the JFET cell contiguous to the first main side 101, with an n-doped gate region 423 formed underneath the gate electrode 433', and adjacent to the first main side. p-doped base regions 421' having a thickness $D_{base} \ll D_{bulk}$ are formed in the bulk layer 10 at peripheral areas of the JFET cell, and adjacent to the first main side. n-doped, preferably (n+)-doped, source regions 422' are formed contiguous to the first main side in an area between the base regions 421' and bulk layer 10. Top sides of the p-doped base regions 421' are contiguous to the first main side outside of the area in which the n doped source regions 422' are formed'.

Isolated, p-doped, preferably (p+)-doped, floating regions 11 having a net doping concentration $N_{float}(p) > N_{D0}$ are formed in the bulk layer at $x_{float} = -(D_{bulk} + D_{base}) / 2 := x_{f,JFET}$ at peripheral regions of the JFET cell. In a vertical direction, the p-doped floating regions 11 have a thickness $D_f \ll D_{bulk}$, preferably $D_f < D_{bulk}/10$, most preferably $D_f < D_{bulk}/100$, and extend in a vertical direction between $x = -d_{f1} = -(D_{bulk} + D_{base} - D_f)/2$ and $x = -d_{f2} = -(D_{bulk} + D_{base} + D_f)/2$. In a first horizontal direction, corresponding to a y-direction in Fig. 1, the p-doped floating regions 11 have a width $w_f/2$, typically in a range $0,5\mu m < w_f < 10\mu m$, preferably $1\mu m < w_f < 3\mu m$ and a spacing $s_f$ typically in a range $1\mu m < s_f < 10\mu m$, preferably $2\mu m < s_f < 5\mu m$.

Again, n-doped enhancement regions 12 having a net doping concentration $N_{enh}(n) > N_{D0}$, preferably $100N_{D0} > N_{enh}(n) > 2N_{D0}$, most preferably $50N_{D0} > N_{enh}(n) > 5N_{D0}$, are formed above and contiguous to a plurality of floating regions, preferably to each floating region, i.e. between the floating region and the first main side. In a vertical direction, the n-doped enhancement regions 12 have a thickness $D_e \ll D_{bulk}$, preferably $D_e < D_{bulk}/10$, most preferably $D_e < D_{bulk}/100$, and extend in a vertical direction between $x = -d_{e1} = -(D_{bulk} + D_{base} - D_f)/2$ and $x = -d_{e2} = -(D_{bulk} + D_{base} - D_f)/2 + D_e$.

An actual JFET device comprises a plurality, typically several hundred to a few thousands, of individual cells as shown in Fig. 5, arranged contiguous to one another in y-direction, each cell having a width $w_{JFET}$ typically in a range $5\mu m < w_{JFET} < 50\mu m$, preferably $10\mu m < w_{JFET} < 20\mu m$. Thus, the p-doped floating regions 11 form a grid with a period $\Lambda y = w_{JFET}$; preferably with $\Lambda_y = w_{JFET}$ within a contiguous bulk layer of the JFET device.

The grid of p-doped floating regions 11 together with the enhancement regions 12 may again be regarded as a floating sublayer which is located within the contiguous bulk layer, and which separates a first homogenous bulk sublayer located above the floating sublayer from a second homogenous bulk sublayer located above the floating sublayer, with both homogenous bulk sublayers having at least approximately identical thickness. Between the first homogenous bulk sublayer and the first main side, another sublayer is formed, which comprises the p-doped base regions 421 as well as a horizontal central region of the bulk layer located between the p-doped base regions 421, and between $x=0$ and $x=-D_{base}$, which may be regarded as a JFET characteristic sublayer.

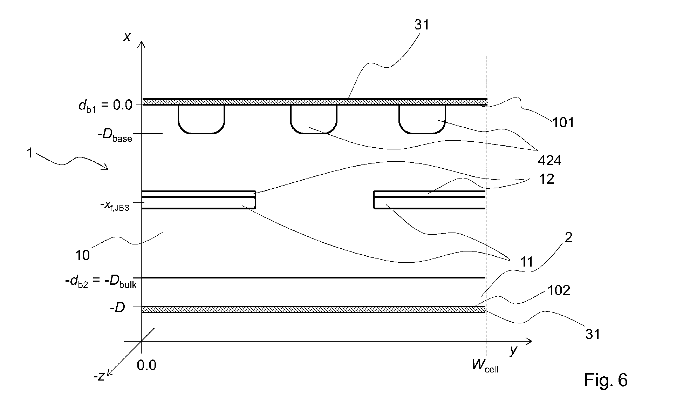

FIG. 6 shows a sectional view of an individual cell of a junction barrier Schottky (JBS) rectifier representing a fourth embodiment of a semiconductor device in accordance with the present invention. The JBS rectifier cell once more comprises a semiconductor slab 1, which was e.g. obtained from a SiC wafer through a plurality of process steps, generally including thinning, layer growing, implant and deposition and diffusion of dopants, and/or dicing. The semiconductor slab has a first main side 101 located at $x=0$ and a second main side 102, said second main side 102 being arranged parallel to the first main side 101 at a distance $D$ in $(-x)$-direction, i.e. at $x = -D$. Again, a bulk layer 10 and an n-doped, preferably (n+)-doped, substrate layer 2 are located between the first main side 101 and the second main side 102, and extend in a direction at least essentially parallel to the first and second main sides 101, 102 and parallel to one another. The bulk layer 10 is (n-)-doped with an at least essentially homogeneous background doping concentration of $N_{D0} = 6\times10^{15}$ cm$^{-3}$ An anode electrode 31 is provided on the first main side, adjacent and contiguous to the bulk layer 10, and with a Schottky contact formed between anode electrode and bulk layer 10. A plurality of p-doped injector regions 424 having a thickness $D_{inj} \ll D_{bulk}$ are formed in the bulk layer 10 contiguous to the first main side.

Isolated, p-doped, preferably (p+)-doped, floating regions 11 having a net doping concentration $N_{float}(p) > N_{D0}$ are formed in the bulk layer at $x_{float} = -(D_{bulk} + D_{inj}) / 2 := x_{f,JBS}$ at peripheral regions of the JBS rectifier cell. In a vertical direction, the p-doped floating regions 11 have a thickness $D_f \ll D_{bulk}$, preferably $D_f < D_{bulk}/10$, most preferably $D_f < D_{bulk}/100$, and extend in a vertical direction between $x = -d_{f1} = -(D_{bulk} + D_{inj} - D_f)/2$ and $x = -d_{f2} = -(D_{bulk} + D_{inj} + D_f)/2$. In a first horizontal direction, corresponding to a y-direction in Fig. 1, the p-doped floating regions 11 have a width $w_f/2$, typically in a range $0,5\mu m < w_f < 10\mu m$, preferably $1\mu m < w_f < 3\mu m$ and a spacing $s_f$ typically in a range $1\mu m < s_f < 10\mu m$, preferably $2\mu m < s_f < 5\mu m$.

Again, n-doped enhancement regions 12 having a net doping concentration $N_{enh}(n) > N_{D0}$, preferably $100N_{D0} > N_{enh}(n) > 2N_{D0}$, most preferably $50N_{D0} > N_{enh}(n) > 5N_{D0}$, are formed above and contiguous to a plurality of floating regions, preferably to each floating region, i.e. between the floating region and the first main side. In a vertical direction, the n-doped enhancement regions 12 have a thickness $D_e \ll D_{bulk}$, preferably $D_e < D_{bulk}/10$, most preferably $D_e < D_{bulk}/100$, and extend in a vertical direction between $x = -d_{e1} = -(D_{bulk} + D_{inj} - D_f)/2$ and $x = -d_{e2} = -(D_{bulk} + D_{inj} - D_f)/2 + D_e$.

An actual JBS rectifier device comprises a plurality, typically several hundred to a few thousands, of individual cells as shown in Fig. 6, arranged contiguous to one another in *y*-direction, each cell having a width $w_{JBS}$ typically in a range $5\mu m < w_{JBS} < 50\mu m$, preferably $10\mu m < w_{JBS} < 20\mu m$. Thus, the p-doped floating regions 11 form a grid with a period $\Lambda_y \approx w_{JBS}$; preferably with $\Lambda y = w_{JBS}$ within a contiguous bulk layer of the JBS rectifier device.

The grid of p-doped floating regions 11 together with the enhancement regions 12 may again be regarded as a floating sublayer which is located within the contiguous bulk layer, and which separates a first homogenous bulk sublayer located above the floating sublayer from a second homogenous bulk sublayer located above the floating sublayer, with both homogenous bulk sublayers having at least approximately identical thickness. Between the first homogenous bulk sublayer and the first main side, another sublayer is formed, which comprises the p-doped base regions 421 as well as a horizontal central region of the bulk layer located between the p-doped base regions 421, and between x=0 and x=-$D_{inj}$, which may be regarded as a JBS rectifier characteristic sublayer.

Preferably, in all embodiments as described above and below, one or more additional n-doped enhancement regions 12 having a net doping concentration $N_{net}(n) > N_{D0}$, preferably $100N_{D0} > N_{enh}(n) > 2N_{D0}$, most preferably $50N_{D0} > N_{enh}(n) > 5N_{D0}$, may be formed below and contiguous to a plurality of p-doped floating regions 11, preferably to each p-doped floating region 11, i.e. between the floating region and the first main side. In a vertical direction, the additional n-doped enhancement regions 12 have a thickness $D_e << D_{bulk}$, preferably $D_e < D_{bulk}/10$, most preferably $D_e < D_{bulk}/100$.

Preferably, in all embodiments as described above and below, one or more additional n-doped enhancement regions 12 having a net doping concentration $N_{net}(n) > N_{D0}$, preferably $100N_{D0} > N_{enh}(n) > 2N_{D0}$, most preferably $50N_{D0} > N_{enh}(n) > 5N_{D0}$, may be formed between, and preferably contiguous to one or more, in particular all pairs of neighboring p-doped floating regions 11 and/or neighboring n-doped enhancement regions 12, i.e. between the floating region and the first main side. In a vertical direction, the additional n-doped enhancement regions 12 have a thickness $D_e << D_{bulk}$, preferably $D_e < D_{bulk}/10$, most preferably $D_e < D_{bulk}/100$.

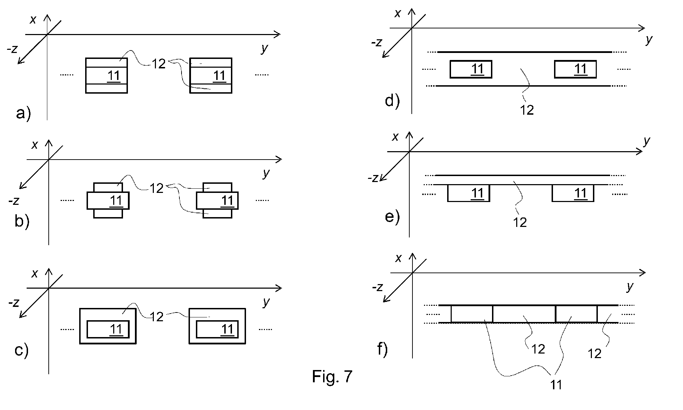

Fig. 7 shows exemplary cross-sectional grid layouts in form of sectional views of grid sections for various exemplary arrangements of additional n-doped enhancement regions 12 as described above. For each enhancement region, an extension of the enhancement region in the -*y*-direction is preferably limited by an extension in the second direction of the floating region adjacent to which the enhancement region is formed, as illustrated in Fig. 7a) and 7b). Fig. 7a) shows a section of an exemplary grid comprising p-doped floating regions 11 with an additional enhancement region formed below and contiguous to each floating region; also referred to as dual buffer structure. A width of the enhancement regions 12 may be reduced or extended as compared to the floating regions as illustrated in Figs. 7b) and 7c), respectively. Fig. 7d) shows a section of an exemplary grid similar to the one of Fig. 7a), albeit with additional enhancement regions 12 between the p-doped floating regions 11 and between the enhancement regions 12 provided above and below them; also referred to as dual buffer structure with full-width buffer. Fig. 7e) shows a section of an exemplary grid with a single contiguous n-doped enhancement region extending above all the p-doped floating regions 11, Fig. 7f) shows a section of an exemplary grid with n-doped enhancement regions 12 provided between neighboring p-doped floating regions 11 only. For all cross-sectional grid layouts with enhancement regions 12 formed above and below the p-doped floating regions 11, the latter need not necessarily be centered relatively to the former with respect to the x-direction, as illustrated by way of example in Fig. 7c). Such a layout may advantageously be generated by means of epitaxy.

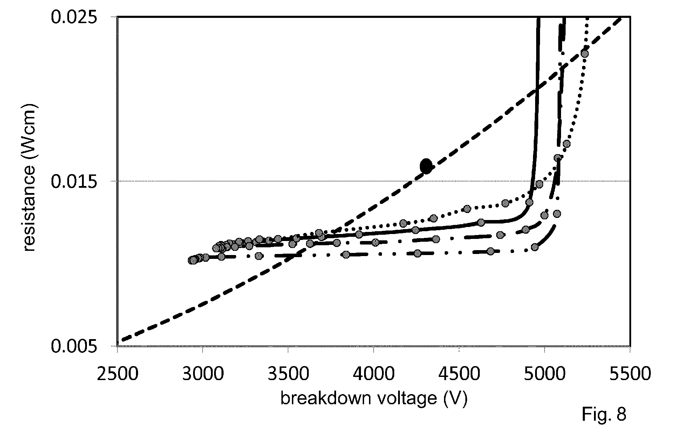

Fig. 8 shows results of numerical simulations of on-state resistance as a function of breakdown voltage for various exemplary arrangements of additional n-doped enhancement regions 12 as described above an illustrated in Fig. 7. Solid curve 1000 again represents the so called limit curve for SiC from Fig. 2, for an n-doped bulk layer with doping concentration of $N_D = 4 \cdot 10^{15}$ cm$^{-3}$ being used as drift layer. For the range of breakdown-voltages shown, the thickness $D$ of the bulk layer varies roughly between 10 $\mu m$ and 200 $\mu m$. Dashed curve 1001 again illustrates the simulations already shown in Fig. 2 for a prior art bulk layer with floating regions, having a fixed thickness of 40 $\mu m$ a doping of $N_{D0} = 6 \times 10^{15}$ cm$^{-3}$; and with p-doped floating regions 11 having a constant width of $s_f = 2\mu m$ provided therein with their (vertical) middle arranged at a (vertical) middle of the bulk layer for various spacings $s_f$. As may be seen, such an arrangement allows to reduce on-state resistance for a range of breakdown voltages between 3700V and 4900V. Outside of this breakdown voltage range, lower on state resistance may be achieved with a conventional bulk layer without floating regions. Dotted curve 1002 illustrates simulation results for a single enhancement layer as e.g. illustrated in Figs. 3-6. While on state resistance is slightly increased in a voltage range between 3700V and 4800V as compared to the prior art bulk layer with floating regions (but still below the on state resistance of the conventional bulk layer), on state resistance is significantly reduced in a voltage range between 4800V and 4900V. In addition, breakdown voltages between 4900V and 5300V may be achieved due to provision of the single enhancement layer, with on state resistance significantly decreased as compared to the conventional bulk layer. Dash-dotted curve 1003 illustrates simulation results for a dual buffer structure as illustrated in Fig. 7a). As may in particular be seen, on state resistance is further decreased in a voltage range between 3700V and 5150V as compared to the single enhancement layer. Dash-double-dotted curve 1004 illustrates simulation results for a dual buffer structure with full-width buffer as illustrated in Fig. 7d). As may in particular be seen, on state resistance is further decreased even further in the voltage range between 3700V and 5150V.

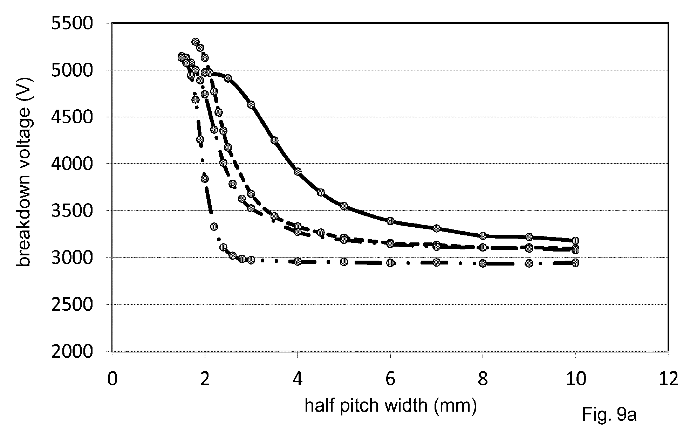

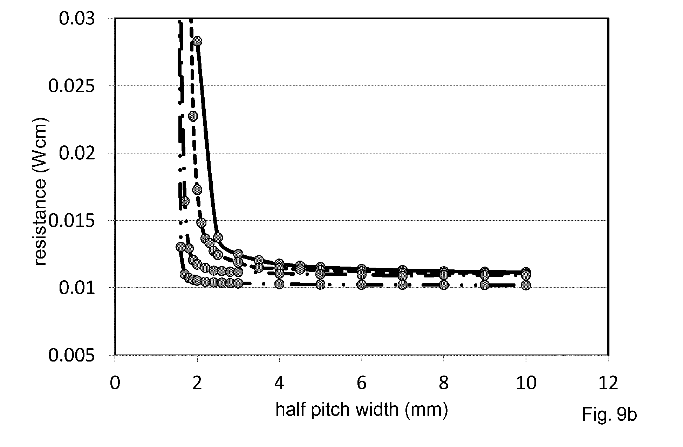

Figs. 9a) and b) illustrate further simulation results for various exemplary arrangements of additional n-doped enhancement regions 12 as discussed in the previous paragraph. It may again be seen that providing n-doped enhancement regions 12, it is possible to reach in excess of 5000 V breakdown voltage or an increase of up to 20% compared with the prior art bulk layer with floating regions. Moreover, it allows for maintaining at the same time low on-resistance and high breakdown voltage. The prior art bulk layer with floating regions is not able to achieve this: In particular, the prior art bulk layer with floating regions reaches 13.7 mΩcm @ 4910 V while the dual buffer structure with full-width buffer as illustrated in Fig. 7d) achieves 11 mΩcm @ 4942 V and/or mΩcm @ 5073 V. A conventional bulk layer with the same breakdown voltage (5000 to 5200 V) would have a 400 K on-resistance of about 20 to 23 mΩcm, as may be seen from the SiC limit curve.

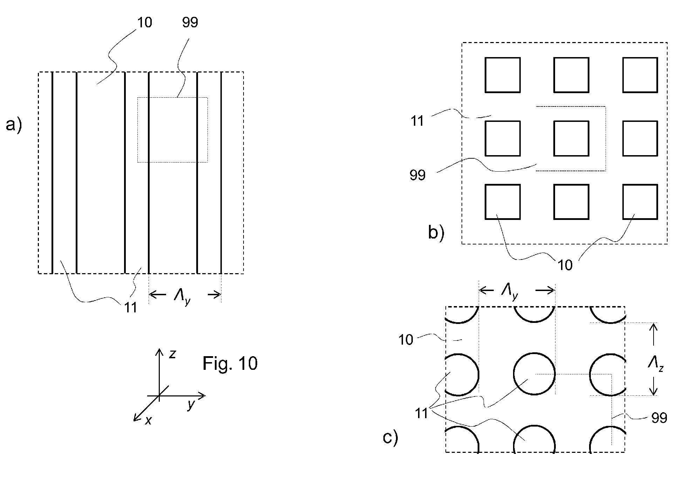

Preferably, in all embodiments as described above, the p-doped, preferably (p+)-doped, floating regions 11 and/or the n-doped enhancement regions 12 extend continuously and/or uniformly in a second horizontal direction represented by the z-direction of Figs. 3-6 and corresponding to a third spatial dimension of the device. The p-doped floating regions 11 and/or the n-doped enhancement regions 12 thus form parallel stripes into the third dimension. Alternatively, p-doped, preferably (p+)-doped, floating regions 11 and/or n-doped enhancement regions 12 may also form a grid in the third dimension, preferably periodic in z-direction with a period of $\Lambda_z$. Fig. 10 schematically shows partial top views of cuts at $x_{float}$ parallel to the y-z-plane through various semiconductor devices in accordance with the present invention, having different, exemplary p-doped floating region layouts. Examplary cell boundaries of MOSFET, JFET or JBS rectifier cells are indicated by rectangle 99.

Instead of a single grid of p-doped floating regions 11 as described above, a plurality of grids of p-doped floating regions 11 having a net doping concentration $N_{float}(p) > N_{D0}$ may be formed at various depths $x_{f1}$, $x_{f2}$, $x_{f3}$, ... with $0 < x_{f1} < x_{f2} < x_{f3} < ...$ in the bulk layer in all embodiments as described above. Preferably, the grids are distributed at least essentially uniformly over the bulk layer in a vertical direction. In particular, for an SBD as described above $x_{f1} \approx x_{f2} - x_{f1} \approx x_{f3} - x_{f2} \approx ...$; where it is assumed that $a \approx b$ implies that $|a-b|/(|a|+|b|) < 10$, preferably $|a-b|/(|a|+|b|) < 100$. n-doped enhancement regions 12 having a net doping concentration $N_{enh}(n) > N_{D0}$, preferably $100N_{D0} > N_{enh}(n) > 2N_{D0}$, most preferably $50N_{D0} > N_{enh}(n) > 5N_{D0}$, are formed above and/or below the p-doped floating regions 11 of at least one, preferably all of the grids. n-doped enhancement regions 12 may also be formed between, and preferably contiguous to one or more, in particular all, pairs of neighboring floating regions and/or neighboring n-doped enhancement regions 12 of at least one grid, preferably each of the grids. One or more, preferably all, of the grids may have identical periods in the second and/or third dimension, i.e. in y- and/or z-direction. One or more, preferably all, grids having identical periods may have a relative phase shift of 0° in y-and/or z-direction with respect to one another. One or more, preferably all, grids having identical periods may have a relative phase shift of 180° in y- and/or z-direction with respect to grids above and/or below. One or more, preferably all, grids may have the same shape, i.e. identical orthogonal projections in x-direction. In particular, if two such grids are aligned in y- and z-direction, their respective orthogonal projections in x-direction will coincide.

Preferably, in all embodiments as described above and below, the conductivity types are interchanged, i.e. all (n-)-, n-, or (n+)-layers and regions as described are replaced by (p)-, p-, or (p+)-layers and regions, respectively, and vice versa.

Unless stated otherwise, all doping concentrations $N$ referred to in this patent application are net doping concentrations, where $N$ is defined as $N := N_D - N_A$ for regions or layers in which a total density of donors $N_D$ is larger than a total density of acceptors $N_A$, i.e. $N_D > N_A$; and as $N := N_A - N_D$ for regions or layers in which a total density of donors $N_D$ is smaller than a total density of acceptors $N_A$. Preferably, in all embodiments as described above, suffixes "-" and "+" after doping type indicators p, n are used to express relative net doping concentrations. In particular, a net doping concentration $N(n+)$ of an (n+)-doped region or layer is larger than a net doping concentration $N(n)$ of an (n)-doped region or layer, which in turn is larger is larger than a net doping concentration $N(n-)$ of an (n-)-doped region or layer. Likewise, a net doping concentration $N(p+)$ of an (p+)-doped region or layer is larger than a net doping concentration $N(p)$ of an (p)-doped region or layer, which in turn is larger than a net doping concentration $N(p-)$ of an (p-)-doped region or layer. Preferably, $N(n+) \geq N(p)$, $N(n) \geq N(p-)$, $N(p+) \geq N(n)$ and/or $N(p) \geq N(n-)$; most preferably, $N(n+) > N(p)$, $N(n) > N(p-)$, $N(p+) > N(n)$ and/or $N(p) > N(n-)$ also hold. On the other hand, where identical suffixes are used with regard to different layers or regions, this shall preferably not be construed to imply that the doping concentrations of said different layers or regions are identical.

Preferably, in all embodiments as described above and below, where a doping concentration or net doping concentration of a region or layer is referred to, this is preferably to be understood as a maximum net doping concentration within said region or layer. In particular for doped regions or layers which were formed including a dopant diffusion process step, a local net doping concentration decays in one or more spatial directions from an area within the region or layer, in which area the local doping concentration equals the maximum net doping concentration.

Preferably, in all embodiments as described above and below, the bulk layer 10 is a layer of unamended net doping concentration by the dopant diffusion process step, i.e. having the net doping concentration as achieved preferably by epitaxial growth of the bulk layer 10. Exemplarily, the bulk layer 10 has a constantly low net doping concentration *N*(n-). Therein, the substantially constant net doping concentration of the bulk layer 10 means that the net doping concentration is substantially homogeneous throughout the bulk layer 10, however without excluding that fluctuations in the net doping concentration within the bulk layer 10 being in the order of a factor of one to five may possibly be present due to e.g. fluctuations in the epitaxial growth process. The final bulk layer thickness and net doping concentration is chosen due to the application needs.

If a region or layer is referred to as being formed or as being provided in the bulk layer (or any other comprising layer or region), it is understood that within the former region or layer the physical properties, in particular the doping type and concentration, of said former region or layer prevail over the properties, in particular the doping type and concentration, of the bulk layer (or the other comprising layer or region as referred to above). On the other hand, when the physical properties, in particular the doping type and concentration, of the bulk layer (or the other comprising layer or region as referred to above) are referred to, physical properties, in particular the doping type and concentration, of the regions or layers formed in the latter or provided in the latter are not taken into account.

Preferably, in all embodiments as described above and below, wide bandgap semiconductor materials, in particular AlN, GaN, or BN may be used for the semiconductor slab 1. Alternatively, Si may also be used for the semiconductor slab 1, albeit with all vertical dimensions as specified above and below preferably increased by a factor of greater than 5, most preferably greater than 10

In all embodiments as described above, the term lateral refers to a direction parallel to the first main side 101. In particular, lateral extension, dimension, distance etc. refers to an extension, dimension, distance, etc. in a direction or plane parallel to the first main side 101. Likewise, the vertical refers to a direction perpendicular to the first main side 101. In particular, vertical extension, dimension, distance etc. refers to an extension, dimension, distance, etc. in a direction perpendicular to the first main side 101. Terms "top", "bottom", "above" and "below" relate the first spatial dimension of the device, in particular to the positive x-direction in the Figures.

Unless stated otherwise, it is assumed that throughout this patent application, a statement $a \approx b$ implies that $|a-b|/(|a|+|b|) < 10$, preferably $|a-b|/(|a|+|b|) < 100$, wherein $a$ and $b$ may represent arbitrary variables as described and/or defined anywhere in this patent application, or as otherwise known to a person skilled in the art. Further, a statement that a is at least approximately equal or at least approximately identical to $b$ implies that $a \approx b$, preferably $a = b$.

It should be noted that the term "comprising" does not exclude other features, in particular elements or steps, and that the indefinite article "a" or "an" does not exclude the plural. Also elements described in association with different embodiments may be combined. It should also be noted that reference signs in the claims shall not be construed as limiting the scope of the claims.

It should be noted that the term " and/or" shall mean that either one of the terms before and after the and/or is valid or both terms are valid, i.e. present in the semiconductor device.

These examples shall not limit the scope of the invention. The above mentioned designs and arrangements are just examples for any kinds of possible designs and arrangements for the various layers and regions. In particular, trench MOSFETS, pin-diodes, etc. represent further exemplary embodiments of semiconductor device in accordance with the present invention.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

*Reference List*

| | |
|---|---|
| 1 | semiconductor slab |
| 10 | bulk layer |
| 101 | first main side |
| 102 | second main side |
| 11 | p-doped floating region |
| 12 | enhancement region |
| 2 | substrate layer |
| 31 | anode electrode |
| 32 | cathode electrode |
| 41 | drain electrode |
| 421, 421' | base region |
| 422, 422' | source region |

| 423 | gate region |
| 424 | injector region |
| 431 | source electrode |
| 432, 432' | insulator |
| 433, 433' | gate electrode |

99 Exemplary MOSFET / JFET / JBS rectifier cell boundaries

**Claims**

1. A semiconductor device comprising

   a) a semiconductor slab (1), in particular a semiconductor wafer or semiconductor die, the semiconductor slab (1)

      i) having a first main side (101) and a second main side (102), said second main side (102) being parallel to the first main side (101) at a distance with respect to a first direction; and
      ii) a bulk layer (10) of a first conductivity type located between the first main side (101) and the second main side (102), and extending in the first direction between a distance $d_{b1}$ from the first main side (101) with $d_{b1} >= 0$ and a distance $d_{b2}$ from the first main side (101) with $d_{b2} > d_{b1}$, and in a second direction perpendicular to the first direction, and with

         (1) a first floating sublayer formed within the bulk layer (10), said first floating sublayer comprising a plurality of, preferably at least 10, floating regions (11) of a second conductivity type different from the first conductivity type and located between a first distance from the first main side (101) and a second distance from the first main side (101), and spaced apart from one another with respect to the second direction,
         (2) a first bulk sublayer located between the first main side (101) and the first floating sublayer;
         (3) a second bulk sublayer located between the first floating sublayer and the second main side (102);

   b) the semiconductor device

      i) further comprising a first main electrode (31) provided on the first main side (101) and a second main electrode (32) provided on the second main side (102),
      **characterized in that**

   c) an enhancement region (12) of the first conductivity type is formed adjacent, preferably contiguous, to at least one of the floating regions (11) in the first floating sublayer,
   d) the enhancement region has a higher doping concentration than the bulk layer (10).

2. The semiconductor device according to claim 1, **characterized in that** a plurality of enhancement regions (12) of the first conductivity type is formed in the first floating sublayer, with at least one of the enhancement regions (12) adjacent to each of the floating regions (11) from the plurality of floating regions (11), the enhancement regions (12) having a higher doping concentration than the bulk layer (10).

3. The semiconductor device according to claim 1 or 2, **characterized in that** the bulk layer (10) comprises a number of $N \geq 1$ further floating sublayers as second, ..., $(N+1)$-th floating sublayer, each floating sublayer comprising a plurality of, preferably at least 10, floating regions (11) of second conductivity type, said floating regions (11) separated from one another with respect to the second direction; and wherein an $n$-th, preferably homogenous, bulk sublayer is located between the $(n-1)$-th floating sublayer and the n-th floating sublayer, and an $(n+1)$-th, preferably homogenous, bulk sublayer is located between the $n$-th floating sublayer and the second main side (102) of the semiconductor device, wherein $n = 2, ... , N+1$, with $N+1$ being a total number of floating sublayers in the bulk layer (10).

4. The semiconductor device according to one of the previous claims, **characterized in that** for the $n$-th floating sublayer, the floating regions (11) of the second conductivity type are located between a distance $^{n}d_{f1}$ from the first main side (101) and a distance $^{n}d_{f2}$ from the first main side (101), with $^{n}d_{f1} > {}^{n-1}d_{f2}$ and $d_{b2} > {}^{n}d_{f2} > {}^{n}d_{f1}$, wherein $n = 1, ... , N+1$, with $N+1$ being the total number of floating sublayers in the bulk layer (10), and wherein $^{0}d_{f2}$ is defined according to $^{0}d_{f2} := d_{b1}$.

5. The semiconductor device according to one of the previous claims, **characterized in that** a thickness $^{n}D_f := {}^{n}d_{f2} - {}^{n}d_{f1}$ of the floating regions (11) is small as compared to a thickness $D_b := d_{b2} - d_{b1}$ of the bulk layer (10), i.e. $10\ ^{n}D_f < D_b$, preferably $100\ ^{n}D_f < D_b$; and/or **in that** $^{n}D_f < 10\mu m$, preferably $^{n}D_f < 2\mu m$; wherein $n \in \{1, ... , N+1\}$, with $N+1$ being a total number of floating sublayers in the bulk layer (10).

6. The semiconductor device according to one of the previous claims, **characterized in that** for the $n$-th floating sublayer, an enhancement region of the first conductivity type is formed adjacent, preferably contiguous, to at least one of the floating regions (11) in said $n$-th floating sublayer, and located between a distance $^{n}d_{e1}$ from the first main side (101) with $^{n}d_{f1} \geq {}^{n}d_{e1} > {}^{n-1}d_{e2} > d_{b1}$ and a distance $^{n}d_{e2}$ from the first main side (101) with $^{n+1}d_{e1} > {}^{n}d_{e2} \geq {}^{n}d_{f2}$, wherein $n \in \{1, ... , N+1\}$, with $N+1$ being a total number of floating sublayers in the bulk layer (10), and wherein $^{0}d_{e2}$ is defined according to $^{0}d_{e2} := d_{b1}$, and $^{N+2}d_{e1}$ is defined according to $^{N+2}d_{e1} := d_{b2}$.

7. The semiconductor device according to the previous claim, **characterized in that** a plurality of enhancement regions (12) of the first conductivity type is formed in the $n$-th floating sublayer, with at least one of the enhancement regions (12) adjacent to each of the floating regions (11) from the plurality of floating regions (11) in the $n$-th floating sublayer, the enhancement regions (12) having a higher doping concentration than the bulk layer (10) wherein $n \in \{1, ... , N+1\}$, preferably $n = 1, ... , N+1$, with $N+1$ being a total number of floating sublayers in the bulk layer (10).

8. The semiconductor device according to one of the previous claims, **characterized in that** a thickness $^{n}D_e := {}^{n}d_{e2} - {}^{n}d_{e1}$ of the enhancement regions (12) is small as compared to a thickness $D_b := d_{b2} - d_{b1}$ of the bulk layer (10), i.e. $10\ ^{n}D_e < D_b$, preferably $100\ ^{n}D_e < D_b$; and/or **in that** $^{n}D_e < 15\mu m$, preferably $^{n}D_e < 5\mu m$; wherein $n \in \{1, ... , N+1\}$, preferably $n = 1, ... , N+1$, with $N+1$ being a total number of floating sublayers in the bulk layer (10).

9. The semiconductor device according to one of the previous claims, **characterized in that** the enhancement regions (12) are restricted in the first direction to a narrow band around the floating regions (11), i.e. that $^{n}d_{f1} - {}^{n}d_{e1} \leq 2\ ^{n}D_f$, preferably $^{n}d_{f1} - {}^{n}d_{e1} \leq {}^{n}D_f/2$, and/or $^{n}d_{e2} - {}^{n}d_{f2} \leq 2\ ^{n}D_f$, preferably $^{n}d_{e2} - {}^{n}d_{f2} \leq {}^{n}D_f/2$; wherein $n \in \{1, ... , N+1\}$, preferably $n = 1, ... , N+1$, with $N+1$ being a total number of floating sublayers in the bulk layer (10)

10. The semiconductor device according to one of the previous claims, **characterized in that** for each enhancement region, an extension of the enhancement region in the second direction is limited by an extension in the second direction of the floating region adjacent to which the enhancement region is formed.

11. The semiconductor device according to one of the previous claims, **characterized in that** $^{n}d_{f1} > {}^{n}d_{e1}$, so that, in particular, enhancement regions (12) are formed above each of the floating regions (11).

12. The semiconductor device according to one of the previous claims, **characterized in that** $^{n}d_{e2} > {}^{n}d_{f2}$, so that, in particular, enhancement regions (12) are formed below each of the floating regions (11).

13. The semiconductor device according to one of the previous claims, **characterized in that** a net doping concentration $N_{enh}$ of the enhancement regions (12) is between $10^{16}cm^{-3}$ and $10^{18}cm^{-3}$, preferably between $5,0\cdot10^{16}cm^{-3}$ and $2,0\cdot10^{17}cm^{-3}$; and/or that $5\ N_{enh} < N_{float}$, preferably $20\ N_{enh} < N_{float}$, where $N_{float}$ is a net doping concentration of the floating regions (11).

14. The semiconductor device according to claim 13, **characterized in that** the net doping concentration $N_{float}$ of the floating regions (11) is between $10^{17}cm^{-3}$ and $10^{19}cm^{-3}$, preferably between $5,0\cdot10^{17}cm^{-3}$ and $2,0\cdot10^{18}cm^{-3}$.

15. The semiconductor device according to one of the previous claims, **characterized in that** the device is a unipolar device, in particular a Schottky barrier diode, a metal-oxide-silicon field effect transistor, a junction field effect transistor, or a junction barrier Schottky rectifier.

Fig. 1

Fig. 2

Fig. 3

Fig. 4

Fig. 5

Fig. 6

Fig. 7

Fig. 8

Fig. 9a

Fig. 9b

a)

10    99

11    $\Lambda_y$

z
x    y

Fig. 10

b)

11
99
10

$\Lambda_y$

c)

10
11
$\Lambda_z$
99

# EP 2 884 538 A1

**EUROPEAN SEARCH REPORT**

Application Number

EP 13 19 7530

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2005 048447 A1 (INFINEON TECHNOLOGIES AG [DE]) 19 April 2007 (2007-04-19) * paragraphs [0053] - [0056], [0061], [0062], [0064]; figures 1-5 * | 1-11, 13-15 | INV. H01L29/36 H01L29/808 H01L29/872 H01L29/06 |
| X | WO 2008/099229 A1 (FREESCALE SEMICONDUCTOR INC; STEFANOV EVGUENIY [FR]; REYNES JEAN-MICHE) 21 August 2008 (2008-08-21) * pages 6,7; figure 1 * | 1-5,8, 13-15 | |
| X | WO 01/11693 A1 (ROCKWELL SCIENCE CENTER LLC [US]) 15 February 2001 (2001-02-15) * page 13, lines 15-30; figure 6c * | 1,4-9, 11-15 | |
| X | EP 0 426 252 A2 (PHILIPS ELECTRONICS UK LTD [GB]; PHILIPS NV [NL]) 8 May 1991 (1991-05-08) * columns 4-6; figure 3 * | 1,2,10, 11,13-15 | |
| X | US 2008/258208 A1 (HIRLER FRANZ [DE] ET AL) 23 October 2008 (2008-10-23) * Fig. 1 and 3 and corresponding text * | 1,2,15 | TECHNICAL FIELDS SEARCHED (IPC) H01L |

The present search report has been drawn up for all claims

| Place of search | Date of completion of the search | Examiner |
|---|---|---|
| Munich | 29 April 2014 | Melodia, Andrea |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 13 19 7530

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2014

| Patent document cited in search report | | Publication date | Patent family member(s) | | | Publication date |
|---|---|---|---|---|---|---|
| DE 102005048447 | A1 | 19-04-2007 | NONE | | | |
| WO 2008099229 | A1 | 21-08-2008 | NONE | | | |
| WO 0111693 | A1 | 15-02-2001 | EP | 1203411 | A1 | 08-05-2002 |
| | | | JP | 2003506903 | A | 18-02-2003 |
| | | | US | 6252258 | B1 | 26-06-2001 |
| | | | WO | 0111693 | A1 | 15-02-2001 |
| EP 0426252 | A2 | 08-05-1991 | DE | 69011809 | D1 | 29-09-1994 |
| | | | DE | 69011809 | T2 | 09-03-1995 |
| | | | EP | 0426252 | A2 | 08-05-1991 |
| | | | GB | 2237930 | A | 15-05-1991 |
| | | | JP | H0648691 | B2 | 22-06-1994 |
| | | | JP | H03155137 | A | 03-07-1991 |
| US 2008258208 | A1 | 23-10-2008 | DE | 102007018631 | A1 | 30-10-2008 |
| | | | US | 2008258208 | A1 | 23-10-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090014792 A1
- US 20100155876 A1